# EUROPEAN PATENT SPECIFICATION

(11) **EP 2 182 087 B1**
(45) Date of publication and mention of the grant of the patent: **25.07.2012**
(21) Application number: 08305755.4
(22) Date of filing: 30.10.2008
(51) Int. Cl.: C23C 14/24, C23C 14/30

(54) **A vacuum vapor coating device for coating a substrate**
Vakuumdampf-Beschichtungsvorrichtung zum Beschichten eines Substrats
Dispositif de revêtement à la vapeur sous vide pour le revêtement d'un substrat

(43) Date of publication of application: 05.05.2010
(73) Proprietor: Essilor International (Compagnie Générale d'Optique), 94220 Charenton-le-Pont (FR)
(72) Inventor: Theoden, Alexis c/o ESSILOR INT. (COMPAGNIE GENERALE D'OPTIQUE), 94220, CHARENTON LE PONT (FR)
(74) Representative: Cabinet Plasseraud

(56) References cited:
- JP-A- 3 053 063
- JP-A- 53 109 881
- JP-A- 57 043 984
- JP-A- 2006 104 497

## Description

The present invention relates to a vacuum vapor coating device for coating a substrate, for example an optical substrate, with a coating material, and a method of coating a substrate using such vacuum vapor coating device.

Physical vapor deposition is well-known as a method for coating substrates, for example, corrosion and oxidation resistant coatings or optical coatings.

Physical vapor deposition corresponds to a variety of method to deposit thin films of a coating material by the condensation of vaporized form of the coating material on a substrate.

Variants of physical vapor deposition method may include:
- electron beam physical vapor deposition, in which the coating material is heated by electron bombardment in high vacuum,
- sputter deposition, in which a glow plasma discharged bombards the coating material sputtering some coating material as a vapor,
- cathodic arc deposition, in which a high power arc directed at the coating material blasts away some of the coating material into vapor,
- pulsed laser deposition, in which a high power laser ablates the coating material into vapor.

Physical vapor deposition methods are implemented thanks to vacuum vapor coating device suitable for coating a substrate.

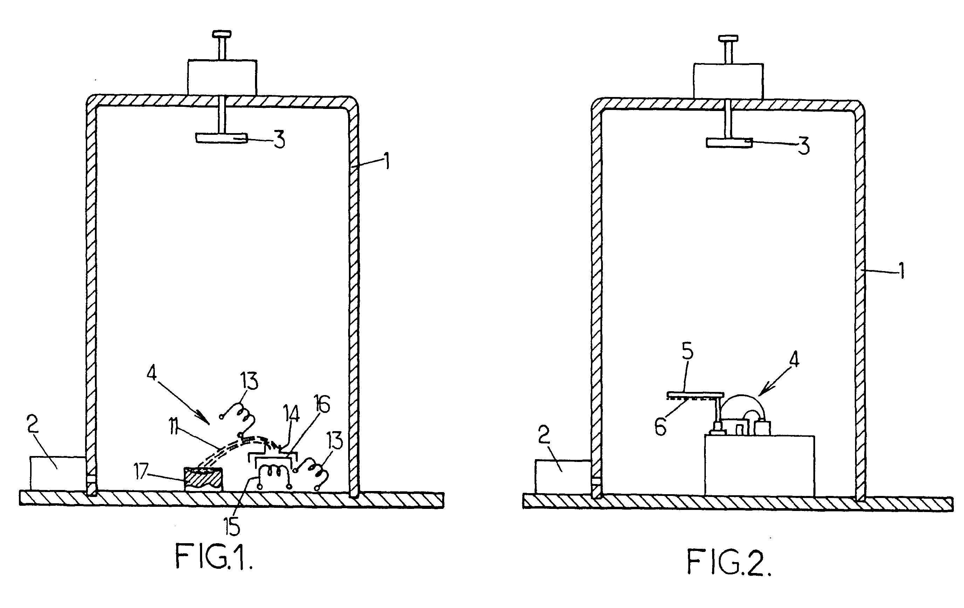

An example of a vacuum vapor coating device for coating a plurality of optical substrates is illustrated in figure 1.

The vacuum vapor coating device illustrated in figure 1, comprises a chamber 1 into which vacuum can be created for example by a vacuum pump 2. The vacuum vapor coating device further comprises a support 3, for receiving substrates for example optical substrates. The support 3 is located in the upper portion of chamber 1.

The lower portion of chamber 1 is provided with a vapor source 4, which here comprises an electron beam gun with a heated filament 15 whose electrons are directed in a beam into a focusing unit 16 after heating.

For example, electron beam 11 can be produced by a tungsten cathode at a high negative potential and focused with a Whenelt cylinder or control grid.

This electron beam 11 may be guided by magnetic guide means 13 into a crucible 17 in which the coating material is located.

Vacuum vapor coating devices may comprise a variety of vapor source. An example of such vapor source is described in US 4,561,382.

Methods of coating a substrate using a vacuum vapor coating device may comprise a transition step in which the vapor source is started but is not yet in a steady state.

During the transition step the vapor source is usually covered with a shutter so as to avoid the coating of the substrate during the transition step. Indeed, during the transition step the evaporation speed is not controlled and therefore the coating process and the deposited thickness may not be precisely controlled.

When the vapor source is in the steady state, the shutter is moved so as to uncover the vapor source and to expose the substrate to the coating material vapors.

Although the use of the shutter allows avoiding that the coating process starts during the transition step of the vapor source, using a shutter presents certain drawbacks. Indeed, during the translation step, the coating material vapor tends to precipitate into solid particule form on the exposed surface of the shutter. The solid particule of the coating material may fall back on the vapor source, damaging or contaminating the vapor source. For example, such solid particule may create short circuit in the vapor source.

Usually in order to prevent such fall back of solid particules on the vapor source, the shutter is cleaned frequently, for example between each coating process.

JP 57043984 A discloses a protection shutter plate installed between a sputter electrode and a shutter plate. The formation of a film on the protection shutter plate eliminates the need of frequently exchanging and cleaning of the shutter plate.

One goal of the present invention consists in providing a vacuum vapor coating device which does not comprise such drawbacks, in particular that does not require to be cleaned between each coating process.

For this purpose, one subject of the invention is a vacuum vapor coating device for coating a substrate with a coating material, the vacuum vapor coating device comprising a chamber into which vacuum can be created, the chamber comprises:
- at least one support for receiving the substrate,
- a vapor source of the coating material,
- a shutter arranged to selectively cover or uncover the vapor source, the shutter comprising first and second surface, the second surface being arranged to face the vapor source when the shutter covers the vapor source,
wherein the second surface is provided with a particule screen made of nonmagnetic materials.

Advantageously, the vacuum vapor coating device according to the invention, in particular the shutter of such vacuum vapor coating device, does not required to be cleaned between each coating process. Furthermore, the particule screen prevents solid particule of coating material from contaminating the vapor source by falling back on the vapor source.

Advantageously, the particule screen also prevents the risk of short circuit of the vapor source, due to the solid particules. Indeed, the particule screen prevents the fall back of the solid particule on the vapor source.

According to further embodiments of the invention, the vacuum vapor coating device according to the invention may comprise the following features alone or in combination:
- the vapor source comprises:
   - an electron beam gun arranged for providing a source of electrons for evaporating the coating material,
   - a crucible arranged for holding the coating material,
   - a plurality of magnets arranged for directing the gun output into the materiel hold in the crucible;
- the vapor source comprises a crucible arranged for holding the coating material and suitable to be heated by ohmic means;
- the device further comprises a shield box surrounding at least part of the crucible and the internal surface of the shield box facing the crucible is provided with a particule screen made of a nonmagnetic material;
- the particule screen is made of stainless steel;
- the substrate to be coated is an optical substrate;
- the openings of the particule screen are larger or equal to 0.5 mm² and smaller or equal to 5 mm²;
- the openings of the particule screen represent at least 50 % of the surface of the screen.

The invention also relates to method of coating a substrate using a vacuum vapor coating device according to the invention.

The method according to the invention may comprises:
- a providing substrate step in which the substrate to be coated is provided to the support mean,
- a mounting screen step in which the particule screen is mounted on the shutter so as to cover the second surface of the shutter,
- a evacuation step in which the chamber is evacuated by a vacuum pump,
- a transition step in which the vapor source is started and the shutter with the particule screen covers the vapor source so as to obtain a steady state,
- a coating step in which the shutter uncovers the vapor source and the substrate is exposed to the coating material vapors so as to coat the substrate.

In the sense of the invention, a "particule screen" comprises a sieve with apertures suitable to let the gas pass and to retain falling solid particules. The particule screen may be a perforated plate, or a meshed wire or a framework of parallel or crisscrossed wires arranged so as to prevent the passage of solid particules of the coating material issue from the deposition of the vapor.

Other features and advantages of the present invention will become apparent in the description of non limiting exemplary embodiments, making references to the following drawing, in which:
- figure 1 is a schematic simplified cross sectional view of a vacuum vapor coating device according to the prior art;
- Figure 2 is a schematic simplified cross sectional view of a vacuum vapor coating device according to the invention;
- Figure 3 is a schematic simplified cross sectional view of a vapor source;
- Figure 4 is a schematic of the second surface of a shutter of a vacuum vapor coating device according to the prior art after two successive coating process;
- Figure 5 is a schematic of the second surface of a shutter of a vacuum vapor coating device according to the invention after six successive coating process;
- Figure 6 is a schematic of the internal surface of a shield box of a vacuum vapor coating device according to the prior art after two successive coating process; and
- Figure 7 is a schematic of an internal surface of a shield box of a vacuum vapor coating device according to the invention after six successive coating process.

For reasons of clarity, the elements shown on the figures are not necessarily to scale.

In the sense of the invention, "particules" shall means small solid particules, typically of the size of comprised between 0.5 mm and 1 cm. Such particules may comprise coating peel off.

Figure 1 has been discussed in the prior art.

The vacuum vapor coating device according to the invention illustrated in figure 2, is adapted for coating a substrate, for example, an optical substrate, particularly plastic lens or spectacle lens.

The vacuum vapor coating device may comprise a chamber 1 into which vacuum can be created by a vacuum pump 2, a support 3, for receiving at least one substrate to be coated, a vapor source 4 of a coating material, and a shutter 5 arranged to selectively cover or uncover the vapor source 4.

The support 3 is located in the upper portion of the chamber 1.

The lower portion of chamber 1 is provided with the vapor source 4 or a plurality of vapor sources, which may comprise an electron beam gun such as the one described below or in US 4,561,382.

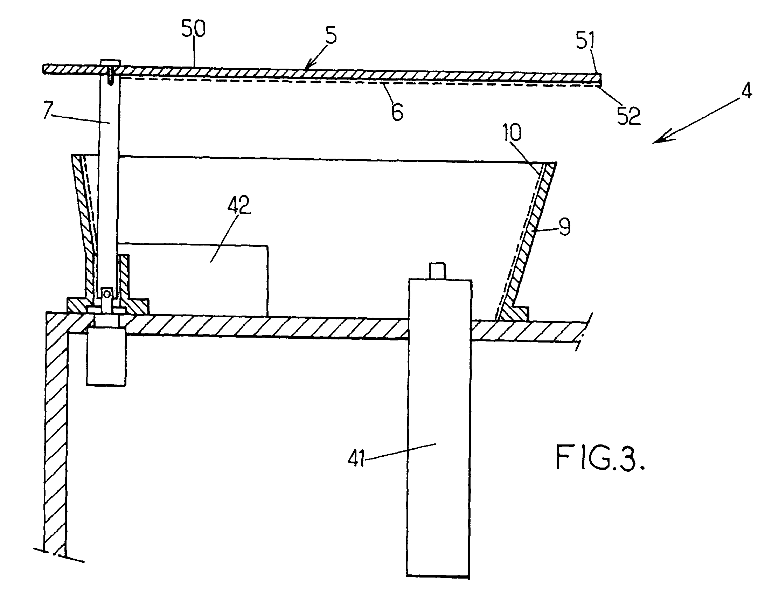

As shown in figure 3, the vapor source 4 may comprise an electron beam gun 41 and a crucible 42.

The electron beam gun 41 may be arranged to provide an electron beam to evaporate the coating material.

The crucible 42 may be arranged to hold the coating material.

The vapor source 4 may also comprise a plurality of magnets (not shown) arranged for directing the electron beam on the coating material hold in the crucible 42.

Optionally, the vacuum vapor coating device according to the invention may comprise a shield box 9 surrounding at least part, for example half, of the crucible 42 to deflect heat from the crucible 42 away from the inner wall of chamber 1.

As illustrated on figure 3, the vapor source 4 may be covered by a shutter assembly 5.

Shutter assembly 5 includes a horizontally rotatable shutter plate 50 attached to one end of a pivoting inner arm 7.

The other end of the pivoting inner arm 7 is supported by an arm support 71 and connected to a rotating mean 8 arranged to rotate the pivoting inner arm 7.

The shutter plate 50 comprises a first 51 and a second 52 surface. The second surface 52 of the shutter plate 50 is arranged to face the vapor source 4, for example the crucible 42, when the shutter plate 50 covers the vapor source, for example, the crucible 42.

According to the invention, the second surface 52 of the shutter 5 is provided with a particule screen 6 made of a nonmagnetic material.

Optionally, the internal surface of the shield box 9 facing the crucible is providing with a particule screen 10 made of nonmagnetic material.

Such particule screens 6 and 10 may be fixed to the shutter 5 or the shield box 9 by any means known from the person skilled in the art at a distance of at least 0.1 mm, for example at least 0.5 mm, for example 1 mm, of the second surface 52 of the shutter or the internal surface of the shield box 9.

Advantageously, the use of such particule screen prevents the solid particules of the coating material issue from the deposition of the vapor from falling back on the crucible 42 or within the electron beam gun.

Advantageously, the particule screens are made of nonmagnetic material so as to avoid any interference with the magnets arranged for directing the electron beam issue from the electron beam gun 41.

According to an embodiment of the invention, the particule screen is a particule screen. In the sense of the invention a "particule screen" is a surface provided with openings of specified size for preventing the passage of solid particules of the coating material issue from the deposition of the vapor.

The openings of the particule screen may be larger or equal to 0.5 mm², for example larger of equal to 0.9 mm², and smaller or equal to 5 mm², for example smaller or equal to 1.5 mm².

The openings of the particule screen may represent at least 50% of the surface of the screen, for example at least 75%, and/or less than 95%, for example less than 90%.

The particule screen may be made of non magnetic material such as non magnetic metals, for example non magnetic stainless steel, aluminum or any non magnetic alloy of aluminum that may resist to sandblasting.

In operation, the electron beam gun 41 is turned on providing an electron beam directed by the plurality of magnets (not shown) on the coating material hold in the crucible 42. The electron beam gun 41 goes trough a transition step during which the electron beam needs to stabilize before reaching a steady state.

During the transition step, the crucible 42 is covered with the shutter plate 50. During the transition step, the vapor of coating material may solidify on the second surface 52 of the shutter plate 50 and/or on the internal surface of the shield box 9 forming small solid particules of coating material.

Advantageously, the particule screens 6 and 10 prevent the fall back of the solid particules of the coating material on the crucible 42. Therefore, the coating material hold in the crucible 42 is not contaminated by the fall back of the solid particules.

Furthermore, the inventors have observed that the solid particules are smaller when providing the shutter 5 and/or the shield box 9 with a particule screen 6 and 10.

According to an embodiment of the invention the particule screen is a particule screen provided on the second surface of the shutter plate 50 and the internal surface of the shield box 9. The vapor of coating material may pass trough the openings of the screen and deposit on the second surface 51 of the shutter plate 50 and on the internal surface of the shield box 9. The particule screen, in particular the openings, is arranged to prevent the passage of solid particule of coating material issue from the deposition of the vapor. Therefore, the solid particule may not fall back on the crucible 42.

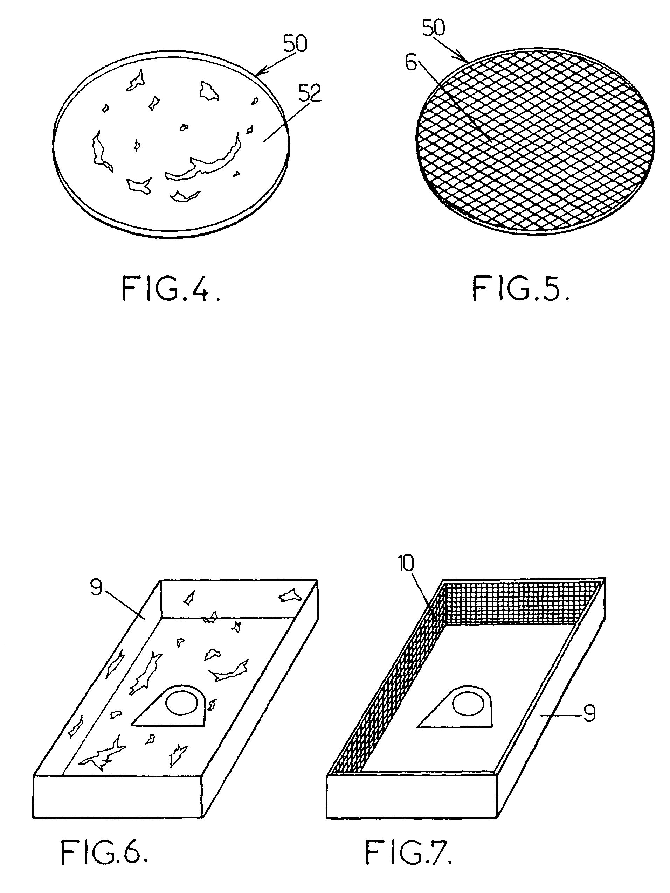

As illustrated by comparing the schematics of figures 4 and 5, the use of a shutter device 5 comprising a particule screen drastically reduces the need of cleaning the second surface of the shutter when using an electron beam gun arranged for providing a source of electrons for evaporating the coating material.

Figure 4 is a schematic of the second surface 52 of a shutter plate 50 used after two successive coating process on a Satis 1200 DLF vacuum vapor coating device commercialized by the company SATIS LOH with a electron beam gun and without a particule screen.

Figure 5 is a schematic of the second surface 52 of a shutter plate 50 after six successive coating process on a Satis 1200 DLF vacuum vapor coating device comprising a particule screen covering the second surface 52 of the shutter plate 50.

As illustrated by comparing the schematics of figures 6 and 7, the use of a shield box 9 comprising a particule screen 10 reduces the need of cleaning the internal surface of the shield box 9.

Figure 6 is a schematic of the internal surface of a shield box 9 used after two successive coating process on a Satis 1200 DLF vacuum vapor coating device with a electron beam gun and without a particule screen.

Figure 7 is a schematic of the internal surface of a shield box 9 after six successive coating process on a Satis 1200 DLF vacuum vapor coating device with a electron beam gun and comprising a particule screen covering the internal surface of the shield box 9.

As can be seen by comparing figures 4 and 6 with figures 5 and 7, it appears that the use of a vapor coating device according to the invention, requires less cleaning of the second surface of the shutter then the use of a coating device of the prior art.

The invention has been described above with the head of an embodiment without limitation of the general inventive concept, in particular the particule screen is not limited to the example disclosed.

## Claims

1. A vacuum vapor coating device for coating a substrate with a coating material, the vacuum vapor coating device comprising a chamber (1) into which vacuum can be created, the chamber (1) comprises:
- at least one support (3) for receiving the substrate,
- a vapor source (4) of the coating material,
- a shutter (5) arranged to selectively cover or uncover the vapor source (4), the shutter (5) comprising first (51) and second (52) surface, the second surface (52) being arranged to face the vapor source (4) when the shutter (5) covers the vapor source (4),
wherein the second surface (52) is provided with a particle screen (6) made of nonmagnetic materials.

2. The device according to claim 1, wherein the vapor source comprises:
- an electron beam gun (41) arranged for providing a source of electrons for evaporating the coating material,
- a crucible (42) arranged for holding the coating material,
- a plurality of magnets arranged for directing the gun output into the materiel hold in the crucible (42).

3. The device according to claim 1, wherein the vapor source (4) comprises a crucible (42) arranged for holding the coating material and suitable to be heated by ohmic means.

4. The device according to any of preceding claims, wherein the device further comprises a shield box (9) surrounding at least part of the crucible (42) and the internal surface of the shield box facing the crucible is provided with a particle screen (10) made of a nonmagnetic material.

5. The device according to any of the preceding claims wherein the particle screen (6, 10) is made of stainless steel.

6. The device according to any of the preceding claims wherein the substrate to be coated is an optical substrate.

7. The device according to any of the preceding claims, wherein the openings of the particule screen (6, 10) are larger or equal to 0.5 mm² and smaller or equal to 5 mm².

8. The device according to any of the preceding claims, wherein the openings of the particule screen (6, 10) represent at least 50 % of the surface of the screen.

9. Method of coating a substrate using a vacuum vapor coating device according to any of the preceding claims.

10. The method according to claim 9, wherein the method comprises:
- a providing substrate step in which the substrate to be coated is provided to the support mean (3),
- a mounting screen step in which the particule screen (6) is mounted on the shutter so as to cover the second surface (52) of the shutter (5),
- a evacuation step in which the chamber (1) is evacuated by a vacuum pump (2),
- a transition step in which the vapor source (4) is started and the shutter (5) with the particule screen (6) covers the vapor source (4) so as to obtain a steady state,
- a coating step in which the shutter (5) uncovers the vapor source (4) and the substrate is exposed to the coating material vapors so as to coat the substrate.

## Patentansprüche

1. Vakuumdampfbeschichtungsvorrichtung zum Beschichten eines Substrats mit einem Beschichtungsmaterial, wobei die Vakuumdampfbeschichtungsvorrichtung eine Kammer (1), in der Vakuum erzeugt werden kann, umfasst, wobei die Kammer (1) umfasst:
- wenigstens eine Halterung (3), um das Substrat aufzunehmen,
- eine Dampfquelle (4) des Beschichtungsmaterials,
- eine Blende (5), welche dazu eingerichtet ist, um die Dampfquelle (4) selektiv zu bedecken oder freizulegen, wobei die Blende (5) eine erste Fläche (51) und eine zweite Fläche (52) umfasst, wobei die zweite Fläche (52) dazu eingerichtet ist, der Dampfquelle (4) zugewandt zu sein, wenn die Blende (5) die Dampfquelle (4) bedeckt,
wobei die zweite Fläche (52) mit einem aus nichtmagnetischen Materialien hergestellten Partikelsieb (6) versehen ist.

2. Vorrichtung gemäß Anspruch 1, wobei die Dampfquelle umfasst:
- eine Elektronenstrahlkanone (41), welche zum Bereitstellen einer Elektronenquelle zum Verdampfen des Beschichtungsmaterials eingerichtet ist,
- einen Tiegel (42), der dazu eingerichtet ist, um das Beschichtungsmaterial zu halten,
- eine Mehrzahl von Magneten, die dazu eingerichtet sind, um den Kanonenausstoß in das in dem Tiegel (42) gehaltene Material zu lenken.

3. Vorrichtung gemäß Anspruch 1, wobei die Dampfquelle (4) einen Tiegel (42) umfasst, der dazu eingerichtet ist, das Beschichtungsmaterial zu halten, und geeignet ist, um durch ohmsche Mittel erhitzt zu werden.

4. Vorrichtung gemäß einem der vorhergehenden Ansprüche, wobei die Vorrichtung ferner ein Abschirmungsgehäuse (9) umfasst, welches wenigstens einen Teil des Tiegels (42) umgibt, und die innere Fläche des Abschirmungsgehäuses, welche dem Tiegel zugewandt ist, mit einem Partikelsieb (10), das aus einem nichtmagnetischen Material hergestellt ist, vorgesehen ist.

5. Vorrichtung gemäß einem der vorhergehenden Ansprüche, wobei das Partikelsieb (6, 10) aus Edelstahl hergestellt ist.

6. Vorrichtung gemäß einem der vorhergehenden Ansprüche, wobei das zu beschichtende Substrat ein optisches Substrat ist.

7. Vorrichtung gemäß einem der vorhergehenden Ansprüche, wobei die Öffnungen des Partikelsiebs (6, 10) größer als oder gleich 0,5 mm² und kleiner als oder gleich 5 mm² sind.

8. Die Vorrichtung gemäß einem der vorhergehenden Ansprüche, wobei die Öffnungen des Partikelsiebs (6, 10) wenigstens 50 % der Fläche des Siebs darstellen.

9. Verfahren zum Beschichten eines Substrats unter Verwendung einer Vakuumdampfbeschichtungsvorrichtung gemäß einem der vorhergehenden Ansprüche.

10. Verfahren gemäß Anspruch 9, wobei das Verfahren umfasst:
- einen Schritt des Bereitstellens eines Substrats, in welchem das zu beschichtende Substrat dem Halterungsmittel (3) bereitgestellt wird,
- einen Schritt des Befestigens des Siebs, in welchem das Partikelsieb (6) an der Blende befestigt wird, um die zweite Fläche (52) der Blende (5) zu bedecken,
- einen Schritt des Evakuierens, in dem die Kammer (1) durch eine Vakuumpumpe (2) evakuiert wird,
- einen Übergangsschritt, in welchem die Dampfquelle (4) gestartet wird und die Blende (5) mit dem Partikelsieb (6) die Dampfquelle (4) bedeckt, um einen stationären Zustand zu erreichen,
- einen Beschichtungsschritt, in welchem die Blende (5) die Dampfquelle (4) freilegt und das Substrat den Beschichtungsmaterialdämpfen ausgesetzt wird, um das Substrat zu beschichten.

## Revendications

1. Dispositif de dépôt vapeur sous vide pour déposer sur un substrat un matériau de revêtement, le dispositif de dépôt vapeur sous vide comprenant une chambre (1) dans laquelle un vide peut être créé, la chambre (1) comprend :
- au moins un support (3) permettant de recevoir le substrat,
- une source de vapeur (4) du matériau de revêtement,
- un volet (5) agencé pour couvrir ou découvrir sélectivement la source de vapeur (4), le volet (5) comprenant une première (51) et une seconde (52) surface, la seconde surface (52) étant agencée pour faire face à la source de vapeur (4) lorsque le volet (5) couvre la source de vapeur (4),
dans lequel la seconde surface (52) est pourvue d'un tamis à particules (6) composé de matériaux non magnétiques.

2. Dispositif selon la revendication 1, dans lequel la source de vapeur comprend :
- un canon à faisceau d'électrons (41) agencé pour fournir une source d'électrons permettant d'évaporer le matériau de revêtement,
- un creuset (42) agencé pour contenir le matériau de revêtement,
- une pluralité d'aimants agencés pour diriger la sortie du canon dans le matériau contenu dans le creuset (42).

3. Dispositif selon la revendication 1, dans lequel la source de vapeur (4) comprend un creuset (42) agencé pour contenir le matériau de revêtement et adapté pour être chauffé par un moyen ohmique.

4. Dispositif selon l'une quelconque des revendications précédentes, dans lequel le dispositif comprend en outre un boîtier de protection (9) entourant au moins une partie du creuset (42) et la surface interne du boîtier de protection faisant face au creuset est pourvue d'un tamis à particules (10) composé d'un matériau non magnétique.

5. Dispositif selon l'une quelconque des revendications précédentes, dans lequel le tamis à particules (6, 10) est en acier inoxydable.

6. Dispositif selon l'une quelconque des revendications précédentes, dans lequel le substrat à revêtir est un substrat optique.

7. Dispositif selon l'une quelconque des revendications précédentes, dans lequel les ouvertures du tamis à particules (6, 10) sont supérieures ou égales à 0,5 mm² et inférieures ou égales à 5 mm².

8. Dispositif selon l'une quelconque des revendications précédentes, dans lequel les ouvertures du tamis à particules (6, 10) représentent au moins 50 % de la surface du tamis.

9. Procédé de revêtement d'un substrat utilisant un dispositif de dépôt vapeur sous vide selon l'une quelconque des revendications précédentes.

10. Procédé selon la revendication 9, dans lequel le procédé comprend :
- une étape de fourniture de substrat dans laquelle le substrat à revêtir est fourni au moyen de support (3),
- une étape de montage de tamis dans laquelle le tamis à particules (6) est monté sur le volet de façon à couvrir la seconde surface (52) du volet (5),
- une étape d'évacuation dans laquelle la chambre (1) est évacuée par une pompe à vide (2),
- une étape de transition dans laquelle la source de vapeur (4) est démarrée et le volet (5) avec le tamis à particules (6) couvre la source de vapeur (4) de façon à obtenir un état régulier,
- une étape de revêtement dans laquelle le volet (5) découvre la source de vapeur (4) et le substrat est exposé aux vapeurs de matériau de revêtement de façon à revêtir le substrat.
